# EUROPÄISCHE PATENTSCHRIFT

(11) **EP 2 591 509 B1**
(45) Veröffentlichungstag und Bekanntmachung des Hinweises auf die Patenterteilung: **03.12.2014**
(21) Anmeldenummer: 11743434.0
(22) Anmeldetag: 07.07.2011
(51) Int. Cl.: H01L 31/048, B32B 17/10

(54) **FIXIERVORRICHTUNG FÜR SOLARZELLEN SOWIE VERFAHREN ZUR FIXIERUNG VON SOLARZELLEN**
SECURING DEVICE FOR SOLAR CELLS AND METHOD FOR SECURING SOLAR CELLS
DISPOSITIF DE FIXATION POUR CELLULES SOLAIRES ET PROCÉDÉ DE FIXATION DE CELLULES SOLAIRES

(30) Priorität: 07.07.2010 DE 102010026338
(43) Veröffentlichungstag der Anmeldung: 15.05.2013
(73) Patentinhaber: Fraunhofer-Gesellschaft zur Förderung der angewandten Forschung e.V., 80686 München (DE)
(72) Erfinder: WIRTH, Harry, 79249 Merzhausen (DE)
(74) Vertreter: Pfenning, Meinig & Partner GbR
(86) Internationale Anmeldenummer: PCT/EP2011/003384
(87) Internationale Veröffentlichungsnummer: WO 2012/003986

(56) Entgegenhaltungen:
- EP-A2- 0 877 427
- DE-A1-102008 046 328
- US-A- 5 968 287

## Beschreibung

Die Erfindung betrifft eine Fixiervorrichtung für Solarzellen auf Glasoberflächen, wobei die Fixiervorrichtung eine Folie aus Einkapselungsmaterial enthält, die eine Vielzahl von Löchern in Form von durchgängigen Aussparungen und Gräben an der Folienoberfläche aufweist. Durch Erzeugung eines Unterdrucks in den Gräben und Löchern kann dann eine Fixierung aufliegender Solarzellen an einer Glasfläche erfolgen. Ebenso betrifft die Erfindung ein Verfahren zur Fixierung von Solarzellen bei der Herstellung von Solarmodulen.

Im Stand der Technik werden Solarmodule hergestellt, indem die Solarzellen elektrisch in Serie zu sog. Zellstrings verbunden werden und zwischen dem Frontglas, einem Einkapselungsmaterial und einer Rückseitenfolie einlaminiert werden.

Bei der Produktion von photovoltaischen Modulen sollen die Solarzellen möglichst wenig mechanische Beanspruchung erfahren. Jede Aufnahme und Ablage der Solarzellen, insbesondere im bereits verbundenen String, erhöht das Bruchrisiko.

Solarzellen mit beidseitiger Kontaktanordnung werden in einem ersten Schritt zu Strings verbunden und dann als String auf dem Stapel aus Glas und Einkapselungsmaterial abgelegt. Für Rückkontakt-Zellen sind Prozesse bekannt, die eine direkte Ablage der Zellen auf dem Stapel aus Glas und Einkapselungsmaterial vorsehen. Damit die Zellen sich nicht wölben oder verschieben, wird ein Aufkleben der Zellen am Einkapselungsmaterial vorgesehen. Hierfür muss die Zelle aufgeheizt werden. Bei dem Kleben können dabei Luftblasen im Einkapselungsmaterial eingeschlossen werden. Das Kleben erfordert dabei eine Haftung, die nicht für alle Zelloberflächen realisierbar ist. Bei Wölbung der Solarzelle kann es so zu einem Abheben der Einkapselungsfolie von Glas kommen.

Für die Fixierung von Solarzellen in anderen Prozessabschnitten der Produktion sind aus der DE 10 2006 007 447 Niederhaltevorrichtungen bekannt. Die WO 2008/104596 A1 beschreibt ein Carrier-System, das bei der Solarmodulproduktion eingesetzt wird. Beide Technologien eignen sich jedoch nicht für die Fixierung auf einem Stapel aus Glas und Einkapselungsmaterial, da sie nur vereinzelte Solarzellen abdecken.

Ausserdem ist aus der EP0877427A2 eine weitere Fixiervorrichtung bekannt, die bei der Solarmodul-Produktion eingesetzt wird.

Für den Transport von Solarzellen und Solarstrings werden in der Produktion häufig Vakuum- oder Bernoulli-Greifer eingesetzt. Derartige Greifer erfordern jedoch einen freien Zugang auf einer Seite der Solarzelle. So werden z.B. Greifer eingesetzt, um die Solarzelle oder Solarzellenstrings von oben auf dem Stapel aus Glas und Einkapselungsmaterial abzulegen. Diese Greifer können aber nicht dort verweilen, da sie Lötprozesse und die Auflage weiterer Schichten, z.B. eines weiteren Einkapselungsmaterials oder eine Rückseitenfolie, behindern würden.

Ausgehend hiervon war es Aufgabe der vorliegenden Erfindung, eine Fixiervorrichtung bereitzustellen, die eine einfache Fixierung der Solarzellen bei der Solarmodul-Produktion ermöglicht.

Diese Aufgabe wird durch die Fixiervorrichtung mit den Merkmalen des Anspruchs 1 und durch das Verfahren mit den Merkmalen des Anspruchs 5 gelöst. Die weiteren abhängigen Ansprüche zeigen vorteilhafte Weiterbildungen auf.

Erfindungsgemäß wird eine Fixiervorrichtung für Solarzellen auf Glasoberflächen bereitgestellt, die mindestens eine aus Einkapselungsmaterial bestehende. Folie enthält, die eine Vielzahl von Löchern sowie mindestens einen die Löchern verbindenden und zu einem Folienrand führenden Kanal aufweist, der an den Folienrändern Anschlussöffnungen zum Anschluss einer Vorrichtung zur Erzeugung eines Unterdrucks aufweist. Die Löcher stellen dabei durchgängige Aussparungen in der Folie dar. Eine Möglichkeit der Gestaltung von Kanälen ist die Prägung von Gräben in die Einkapselungsfolie. Die Gräben verlaufen aus der Mitte der Zellmatrix zu deren Rand, so dass jede einzelne Zelle eine Verbindung zu dem Kanalsystem besitzt. Dabei ist es bevorzugt, dass die Folie aus dem Einkapselungsmaterial so auf das Glas gelegt wird, dass die Gräben zur Glasseite offen sind.

Eine weitere bevorzugte Variante sieht vor, dass die mindestens eine Folie auf der ersten Folienoberfläche in den nicht mit Löchern versehenen Bereichen zumindest teilweise Noppen oder eine andere erhabene Struktur zur Reduzierung der Kontaktfläche zwischen Folie und Solarzelle aufweist. Durch die Prägung derartiger Noppen kann verhindert werden, dass die Folie aus dem Einkapselungsmaterial beim Löten aufschmilzt und Luftblasen einschließt. Damit die Noppen die Ausbildung eines Unterdrucks zur Fixierung der Zelle zulassen, kann ein erhabener Ring um die Löcher strukturiert werden.

Erfindungsgemäß wird ebenso ein Verfahren zur Fixierung von Solarzellen bei der Herstellung von Solarmodulen bereitgestellt, bei dem auf einer Glasfläche eine erfindungsgemäße Fixiervorrichtung angeordnet wird und auf der Fixiervorrichtung mindestens eine Solarzelle angeordnet wird. Durch Anschluss einer Vorrichtung zur Erzeugung eines Unterdrucks wird in den Löchern ein Unterdruck erzeugt, durch den die Fixierung an der Gasfläche erfolgt.

Die Fixiervorrichtung, d.h. die Folie, weist ein System von Kanälen und Löchern auf, die es ermöglichen, durch Greifer von oben aufgelegte Solarzellen in ihrer Position zu fixieren. Die Fixierung erfolgt durch Unterdruck, der seitlich am Rand der Folie aufgebracht wird. Die Einkapselungsfolie liegt zu diesem Zeitpunkt bereits auf der Frontglasscheibe auf. Das erfindungsgemäße Verfahren verhindert ein Verrutschen oder Verformen von Solarzellen nach Ablage auf dem Stapel aus Glas und der Folie aus Einkapselungsmaterial.

In der Solarmodul-Produktion reduziert dieses Verfahren das Bruchrisiko von Solarzellen, da diese nur noch ein einziges Mal bewegt und abgelegt werden. Weiterhin kann der Prozess der Modulherstellung vereinfacht werden, indem die üblichen Zwischenschritte der String-Herstellung und des String-Transportes entfallen. Die Zellen können direkt in der fixierten Position verbunden werden, beispielsweise durch selektives Löten oder Kleben, das vor oder während der Lamination erfolgt. Nach Auflegen und ggf. Verbinden der Zellen kann eine weitere Folie aus Einkapselungsmaterial und/oder eine Rückseitenfolie aufgelegt werden. Die Verbindung von Zellen auf der Folienunterlage eignet sich insbesondere für Rückkontaktzellen, da diese ausschließlich über die Rückseite kontaktiert werden müssen.

Nach der Ablage der Solarzellen kann der bewegliche Greifer entfernt werden, ohne dass die Solarzellen ihre Lage oder Form ändern. Die weiteren Schritte der Modulfertigung, z.B. die elektrische Verbindung durch selektives Löten oder die Ergänzung des Schichtaufbaus, können auf dem Stapel aus Glas und Einkapselungsmaterial erfolgen.

Die erfindungsgemäße Fixiervorrichtung und das erfindungsgemäße Verfahren verhindern ein Verrutschen oder Verformen von Solarzellen nach Ablage auf dem Stapel aus Glas und Einkapselungsmaterial. Somit kann eine besonders schonende Verarbeitung von Solarzellen erfolgen, die nur ein einziges Mal bewegt werden müssen. Weiterhin kann der Prozess der Modulherstellung vereinfacht werden, indem die Zwischenschritte der String-Herstellung und des String-Transportes entfallen. Die Solarzellen können direkt auf dem Stapel aus Glas und Einkapselungsmaterial verbunden werden, beispielsweise durch selektives Löten.

Das erfindungsgemäße Verfahren kann zur Herstellung von Wafer-basierten Solarmodulen verwendet werden, bevorzugt für die Verarbeitung von Rückkontakt-Solarzellen.

Anhand der nachfolgenden Figuren soll der erfindungsgemäße Gegenstand näher erläutert werden, ohne diesen auf die hier gezeigten spezifischen Ausführungsformen einschränken zu wollen.

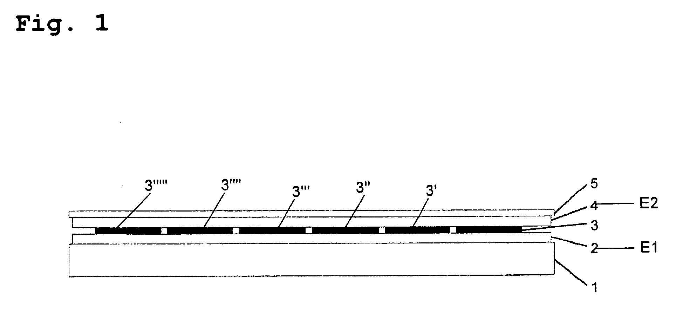

Fig. 1 zeigt den Aufbau eines Solarzellenmoduls gemäß dem Stand der Technik. Hierbei ist auf einer Frontglasscheibe 1 eine Folie aus einem Einkapselungsmaterial 2 angeordnet. Auf dieser Folie befinden sich die Solarzellen 3 bis 3''''', die wiederum von einer weiteren Folie aus einem Einkapselungsmaterial 4 bedeckt sind. Auf dieser Folie ist dann noch eine Rückseitenfolie 5 angeordnet.

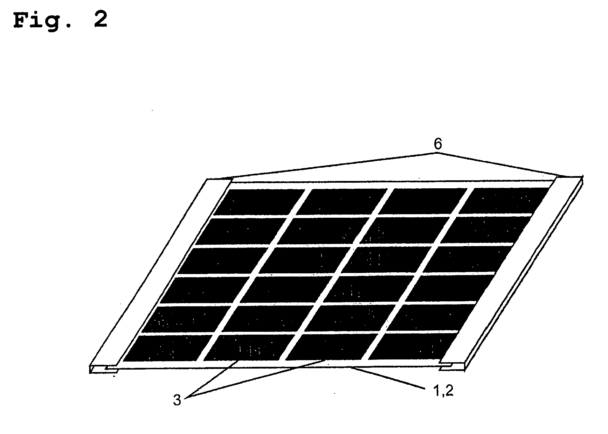

Fig. 2 zeigt eine Draufsicht eines derartigen Solarzellenmoduls gemäß Fig. 1. Hier sind die einzelnen Solarzellen 3 auf dem Frontglas 1 und der Folie aus Einkapselungsmaterial 2 angeordnet. An den Rändern befinden sich Vorrichtungen 6, über die Luft angesaugt wird, so dass an den Stellen der Zellauflage ein Unterdruck entsteht.

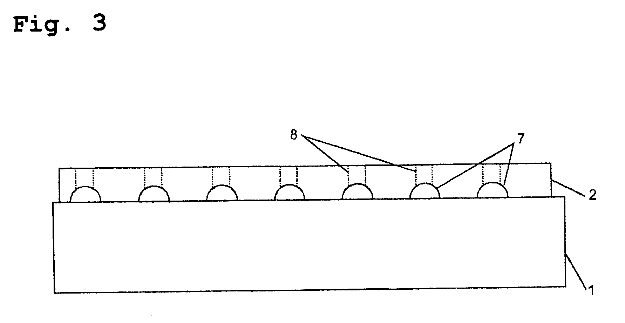

In Fig. 3 ist ein Querschnitt einer erfindungsgemäßen Fixiervorrichtung dargestellt. Die Folie aus Einkapselungsmaterial 2, die auf dem Frontglas 1 angeordnet ist, weist hierbei Kanäle 7 auf. Weiterhin enthält die Folie eine Lochmatrix aus Löchern 8, die den Luftdurchtritt von der Seite der Gräben zur dem Frontglas 1 abgewandten Oberfläche der Folie aus Einkapselungsmaterial erlauben, wo die Zellen fixiert werden sollen.

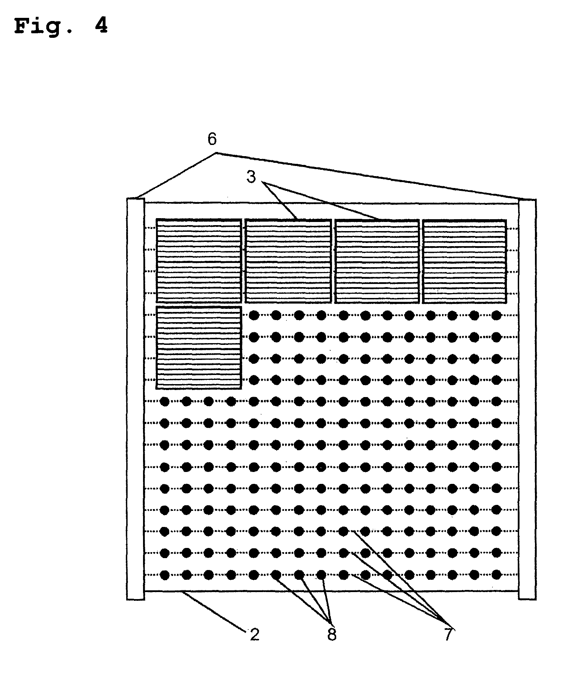

In Fig. 4 ist eine Draufsicht einer erfindungsgemäßen Fixiervorrichtung dargestellt. Auch hier weist die Folie aus Einkapselungsmaterial 2 Kanäle 7 und eine Lochmatrix aus Löchern 8 auf. Auf der Folie aus Einkapselungsmaterial 2 sind Solarzellen 3 angeordnet. An beiden Folienrändern der Folie aus Einkapselungsmaterial 2 schließen sich seitlich hermetische Klammern 6 zur Luftabsaugung an, so dass in den Bereichen der Folie 2, wo Solarzellen 3 angeordnet sind, ein Unterdruck erzeugt wird, durch den die Zellen auf der Folie fixiert werden.

## Patentansprüche

1. Fixiervorrichtung für Solarzellen auf Glasoberflächen enthaltend mindestens eine Folie bestehend aus Einkapselungsmaterial, die eine Vielzahl von Löchern und mindestens einen die Löchern verbindenden und zu einem Folienrand führenden Kanal aufweist, der an den Folienrändern Anschlussöffnungen zum Anschluss einer Vorrichtung zur Erzeugung eines Unterdrucks aufweist, **dadurch gekennzeichnet, dass** die Löcher durchgängige Aussparungen in der Folie darstellen.

2. Fixiervorrichtung nach Anspruch 1, **dadurch gekennzeichnet, dass** die Kanäle in Form von in Richtung der Oberfläche der Folie offenen Gräben ausgebildet sind.

3. Fixiervorrichtung nach dem vorhergehenden Anspruch, **dadurch gekennzeichnet, dass** die Gräben einen Querschnitt aufweisen, der dem 0,05- bis 5-fachen, bevorzugt dem 0,1- bis 3-fachen, besonders bevorzugt dem 0,25- bis 1,5-fachen des Quadrats der Foliendicke entspricht.

4. Fixiervorrichtung nach dem vorhergehenden Anspruch, **dadurch gekennzeichnet, dass** die mindestens eine Folie auf der ersten Folienoberfläche in den nicht mit Löchern versehenen Bereichen zumindest teilweise erhabene Strukturen, z.B. Noppen zur Reduzierung der Kontaktfläche zwischen Folie und Solarzelle aufweist.

5. Verfahren zur Fixierung von Solarzellen bei der Herstellung von Solarmodulen, bei dem auf einer Glasoberfläche eine Fixiervorrichtung nach einem der vorhergehenden Ansprüche angeordnet wird, auf der Fixiervorrichtung mindestens eine Solarzelle angeordnet wird und durch Anschluss einer Vorrichtung zur Erzeugung eines Unterdrucks in den Löchern der Fixiervorrichtung ein Unterdruck erzeugt wird, durch den die Fixierung der mindestens einen Solarzelle an der Glasoberfläche und Fixiervorrichtung erfolgt.

6. Verfahren nach Anspruch 5, **dadurch gekennzeichnet, dass** der Unterdruck mit einer Vakuumpumpe erzeugt wird.

## Claims

1. Device for securing solar cells to glass surfaces, containing at least one film consisting of encapsulating material that has a plurality of holes and at least one channel that connects the holes and leads to a film edge, said channel having connection openings on the film edges for the connection of a device for the generation of negative pressure, **characterised in that** the holes represent continuous recesses in the film.

2. Securing device according to claim 1, **characterised in that** the channels are designed in the form of trenches that are open in the direction of the surface of the film.

3. Securing device according to the preceding claim, **characterised in that** the trenches have a cross section that corresponds to 0.05 to 5 times, preferably 0.1 to 3 times, particularly preferably 0.25 to 1.5 times the square of the film thickness.

4. Securing device according to the preceding claim, **characterised in that** the at least one film has, on the first film surface in the regions that are not provided with holes, at least partially raised structures, e.g. nubs for reducing the contact surface between the film and the solar cell.

5. Method for securing solar cells during the production of solar modules, in which a securing device according to one of the preceding claims is arranged on a glass surface, at least one solar cell is arranged on the securing device and negative pressure is generated in the holes of the securing device by connecting a device for the generation of negative pressure, with which the securing of the at least one solar cell to the glass surface and fixing device takes place.

6. Method according to claim 5, **characterised in that** the negative pressure is generated by a vacuum pump.

## Revendications

1. Dispositif de fixation pour des cellules solaires sur des surfaces en verre contenant au moins une feuille en matériau d'encapsulage, qui comporte une pluralité de trous et au moins un canal qui relie lesdits trous et mène vers un bord de la feuille et qui, au niveau des bords de la feuille, comporte des orifices de raccordement permettant de connecter un dispositif destiné à générer une dépression, **caractérisé en ce que** les trous constituent des évidements débouchant dans la feuille.

2. Dispositif de fixation selon la revendication 1, **caractérisé en ce que** les canaux sont réalisés sous la forme de sillons ouverts vers la surface de la feuille.

3. Dispositif de fixation selon la revendication précédente, **caractérisé en ce que** les sillons ont une section transversale qui correspond à 0,05 à 5 fois, de préférence à 0,1 à 3 fois, encore mieux à 0,25 à 1,5 fois le carré de l'épaisseur de la feuille.

4. Dispositif de fixation selon la revendication précédente, **caractérisé en ce que** ladite au moins une feuille comporte sur la première surface de feuille, dans les zones non munies de trous, des structures au moins partiellement en relief, telles que des picots, en vue de réduire la surface de contact entre la feuille et la cellule solaire.

5. Procédé permettant la fixation de cellules solaires lors de la fabrication des modules solaires, dans lequel un dispositif de fixation selon l'une quelconque des revendications précédentes est disposé sur une surface en verre, au moins une cellule solaire est disposée sur le dispositif de fixation et, par le raccordement d'un dispositif destiné à générer une dépression, une dépression est produite dans les trous du dispositif de fixation, ce qui assure la fixation de ladite au moins une cellule solaire sur la surface en verre et le dispositif de fixation.

6. Procédé selon la revendication 5, **caractérisé en ce que** la dépression est générée par une pompe à vide.
